# EUROPÄISCHE PATENTANMELDUNG

(11) **EP 1 376 707 A2**
(43) Veröffentlichungstag der Anmeldung: **02.01.2004**
(21) Anmeldenummer: 03009531.9
(22) Anmeldetag: 28.04.2003
(51) Int. Cl.: H01L 31/12, H01L 31/167

(54) **Optokoppler**

(30) Priorität: 25.06.2002 DE 10228390
(71) Anmelder: KROHNE MESSTECHNIK GMBH & CO. KG, 47058 Duisburg (DE)
(72) Erfinder: Florin, Wilhelm, 47198 Duisburg (DE)
(74) Vertreter: Gesthuysen, von Rohr & Eggert

(57) **Zusammenfassung**

Dargestellt und beschrieben ist ein Optokoppler, mit zwei Photodioden (1, 2) und einem Lichtleiter (3), wobei von den beiden Photodioden (1, 2) die eine als Sendediode (1) und die andere als Empfangsdiode (2) vorgesehen ist und mit dem Lichtleiter (3) von der Sendediode (1) ausgesandtes Licht auf die Empfangsdiode (2) geführt wird.

Erfindungsgemäß ist vorgesehen, daß die Sendediode (1) und die Empfangsdiode (2) im Abstand voneinander auf einer Leiterplatte (4) angeordnet sind und als Lichtleiter (3) ein ebenfalls auf der Leiterplatte angeordneter Kunststoff- oder Glaskörper vorgesehen ist. Damit läßt sich ein einfach aufgebauter Optokoppler erzielen, der auch unter Explosionsschutzgesichtspunkten sicher verwendbar ist.

## Beschreibung

Die Erfindung betrifft einen Optokoppler, mit zwei Photodioden und einem Lichtleiter, wobei von den beiden Photodioden die eine als Sendediode und die andere als Empfangsdiode vorgesehen ist und mit dem Lichtleiter von der Sendediode ausgesandtes Licht auf die Empfangsdiode geführt wird.

Solche eingangs beschriebenen Optokoppler werden häufig zur digitalen Datenübertragung verwendet, insbesondere nämlich dann, wenn eine galvanische Trennung zweier Stromkreise erzielt werden muß, z.B. aufgrund von Explosionsschutzvorschriften, wie im folgenden erläutert:

In verschiedenen technischen Bereichen, wie z.B. in der Durchfluß- und Füllstandsmeßtechnik, müssen bei den verwendeten Geräten häufig Maßnahmen zur Erzielung eines Explosionsschutzes ergriffen werden. Dabei müssen bezüglich des Explosionsschutzes unterschiedlich zu behandelnde Bereiche voneinander getrennt werden. Eine solche Trennung muß insbesondere für solche Meßgeräte vorgesehen werden, die über eine separate Netzleitung mit elektrischer Energie versorgt werden und üblicherweise als Vierleitergeräte bezeichnet werden. In Abgrenzung zu solchen Vierleitergeräten wird von Zweileitergeräten gesprochen, wenn die Versorgung mit elektrischer Energie einerseits und die Datenübertragung andererseits über eine gemeinsame Leitung erfolgt, so daß keine separate Netzleitung erforderlich ist.

Bei den angesprochenen Vierleitergeräten erfolgt die Versorgung der Geräte mit elektrischer Energie typischerweise unter der Zündschutzart "Erhöhte Sicherheit". Bei der Zündschutzart "Erhöhte Sicherheit" werden Maßnahmen getroffen, um mit einem erhöhten Grad an Sicherheit die Möglichkeit unzulässig hoher Temperaturen und des Entstehens von Funken oder Lichtbögen im Inneren oder an äußeren Teilen elektrischer Betriebsmittel, bei denen diese im normalen Betrieb nicht auftreten, zu verhindern. Als Zündschutzart auf der Sensorseite, also im Falle eines magnetisch-induktiven Durchflußmessers auf der Seite der Elektroden oder im Falle eines Coriolis-Massendurchflußmeßgeräts auf der Seite der Treiber und der Sensorspulen, ist im Regelfall die Zündschutzart "Eigensicherheit" vorgesehen. Bei der Zündschutzart "Eigensicherheit" wird die Energie im Stromkreis so gering gehalten, daß keine zündfähigen Funken, Lichtbögen oder Temperaturen entstehen können. Auch ein Kurzschluß kann also bei der Zündschutzart "Eigensicherheit" zu keinem zündfähigen Funken und damit auch zu keiner Explosion führen.

Eine Möglichkeit, die Zündschutzart "Eigensicherheit" zu realisieren, besteht in der sogenannten "Barrierentechnik", bei der im wesentlichen Begrenzungsmaßnahmen gegenüber einer "sicheren Erde" verwendet werden. Der Bezug zu dieser "sicheren Erde" birgt meßtechnisch gesehen jedoch das Risiko von Störungen durch erzeugte Erdschleifen und ist darüber hinaus auch deshalb fehleranfällig, da der Anschluß der "sicheren Erde" durch den Verwender des entsprechenden Meßgeräts bei dessen Inbetriebnahme im allgemeinen selbst gewährleistet werden muß. Insofern hat es sich als vorteilhaft herausgestellt, sicher galvanisch getrennte Stromkreise zu verwenden, so daß keine Begrenzungsmaßnahmen gegenüber einer "sicheren Erde" erforderlich sind.

Bei Vierleitergeräten muß nun über die sicher galvanisch getrennten Stromkreise einerseits elektrische Energie übertragen werden und andererseits ein typischerweise digitaler Datenaustausch erfolgen. Die elektrische Energie wird im allgemeinen über DC/DC-Wandler mit sicher trennenden Übertragern bereitgestellt. Die digitale Datenübertrag erfolgt dagegen im allgemeinen über Optokoppler.

Damit diese für die digitale Datenübertragung verwendeten Optokoppler dem Explosionsschutz genügen, werden Mindestabstände für sogenannte Luft- und Kriechstrecken gefordert. So muß z.B. der Abstand zwischen den galvanisch getrennten Stromkreisen 10 mm Kriechweg oder 1 mm feste Isolierung betragen, wenn die Spannung auf maximal 375 V begrenzt ist, also z.B. eine Versorgung über das 230 V-Wechselstromnetz erfolgt. Damit dürfen jedoch nur bestimmte Optokoppler verwendet werden, die über eine besondere Zulassung verfügen, die wenigstens 1 mm feste Isolierung zwischen der Sendediode und der Empfangsdiode einhalten, bei denen die sicherheitstechnisch maximale Temperatur der Isolierschicht garantiert ist und bei denen der zuvor genannte Abstand von 10 mm Kriechweg auf der Leiterplatte eingehalten wird, auf der sie montiert werden. Der Abstand von wenigstens 10 mm Kriechweg auf der Leiterplatte betrifft dabei insbesondere den Pinabstand der Optokoppler sowie den Abstand der Pads auf der Leiterplatte. Optokoppler, die die zuvor genannten Anforderungen erfüllen, sind jedoch verhältnismäßig teuer, liegen meistens als bedrahtete Bauelemente vor und sind damit teuer zu montieren, weisen wegen der zuvor genannten erforderlichen Abstände und der zusätzlichen Schutzmaßnahmen im allgemeinen eine große Bauform auf und zeigen aufgrund des wenigstens 1 mm betragenden Isolierabstandes eine schlechte Lichtkopplung. Daher wird mit solchen Optokopplern meist auch keine schnelle Datenübertragung erzielt.

Damit ist es die Aufgabe der Erfindung, einen solchen Optokoppler bereitzustellen, der preisgünstig, einfach aufgebaut und einfach zu montieren ist und trotzdem den Explosionsschutzanforderungen genügt.

Die zuvor hergeleitete und aufgezeigte Aufgabe ist ausgehend von dem eingangs beschriebenen Optokoppler dadurch gelöst, daß die Sendediode und die Empfangsdiode im Abstand voneinander auf einer Leiterplatte angeordnet sind und als Lichtleiter ein ebenfalls auf der Leiterplatte angeordneter Kunststoff- oder Glaskörper vorgesehen ist.

Mit dem als Kunststoff- oder Glaskörper ausgebildeten Lichtleiter wird das von der Sendediode ausgesandte Licht, basierend auf dem Prinzip der Totalreflektion, zur Empfangsdiode geführt, so daß die Sendediode und die Empfangsdiode grundsätzlich beliebig angeordnet sein können. Dabei kann vorgesehen sein, daß, wie bei herkömmlichen Optokopplern, der Abstrahlbereich der Sendediode auf den Empfangsbereich der Empfangsdiode ausgerichtet ist, Sendediode und Empfangsdiode also aufeinander zu gerichtet sind. Gemäß einer bevorzugten Weiterbildung der Erfindung ist jedoch vorgesehen, daß der Abstrahlbereich der Sendediode und der Empfangsbereich der Empfangsdiode von der Leiterplatte weg gerichtet sind, nämlich vorzugsweise parallel zueinander von der Leiterplatte aus gesehen nach oben weisen. Dem entspricht im Rahmen einer Oberflächenmontage ein einfaches Aufsetzen der Photodioden auf die Leiterplatte, ohne eine umständliche Ausrichtung der Photodioden aufeinander vornehmen zu müssen.

Als Material für den Lichtleiter sind grundsätzlich alle bekannten Glas- oder Kunststoffmaterialen verwendbar. Bei der Verwendung in einem explosionsgefährdeten Bereich muß jedoch die Nichtbrennbarkeit bzw. zumindest eine schwere Entflammbarkeit sowie jedenfalls eine entsprechende Temperaturstabilität des Materials für den Lichtleiter gewährleistet sein. Gemäß einer bevorzugten Weiterbildung der Erfindung ist vorgesehen, daß der Lichtleiter aus Polycarbonat hergestellt ist. Ferner hat sich eine Herstellung des Lichtleiters in einem Spritzgußverfahren als besonders effektiv herausgestellt.

Der als Kunststoff- oder Glaskörper ausgebildete Lichtleiter gewährleistet also, daß von der Sendediode ausgesandtes Licht per Totalreflektion an der Wand oder an den Wänden des Kunststoff- oder Glaskörpers auf die Empfangsdiode trifft. Dies wird dadurch erreicht, daß einerseits als Material für den Körper ein solches Material verwendet wird, das gegenüber der Umgebung, typischerweise Luft, einen hinreichend hohen Brechungsindex bei den verwendeten Lichtwellenlängen aufweist, und daß andererseits eine solche geometrische Form des Körpers gewählt wird, daß bei der verwendeten Anordnung von Sendediode, Empfangsdiode und Kunststoff- bzw. Glaskörper beim Auftreffen des von der Sendediode ausgesandten Lichts auf eine Begrenzungsfläche des Körpers jeweils der gegen das Lot der Begrenzungsfläche gemessene Grenzwinkel der Totalreflektion überschritten wird. Mit anderen Worten muß bezüglich des als Kunststoff- bzw. Glaskörpers ausgebildeten Lichtleiters gewährleistet sein, daß sein Material optisch dichter als seine Umgebung ist und daß das von der Sendediode ausgehende Licht in seinem Inneren immer möglichst streifend auf seine Begrenzungsflächen fällt.

Dadurch daß erfindungsgemäß ein fester Kunststoff- bzw. Glaskörper als Lichtleiter vorgesehen ist und keine biegsame Faser, ist im übrigen auch die Einkopplung des Lichtes in den Lichtleiter erleichtert. Insbesondere entfällt eine aufwendige Ausrichtung eines als Faser ausgebildeten Lichtleiters auf die Sendediode. Entsprechendes gilt auch für die Auskopplung des Lichtes aus dem Lichtleiter auf die Empfangsdiode. Dabei sind grundsätzlich nämlich keine Fokussiereinrichtungen zur Fokussierung des Lichtes auf die Empfangsdiode erforderlich. Gemäß einer bevorzugten Weiterbildung der Erfindung ist jedoch eine Fokussiereinrichtung vorgesehen, mit der das von der Sendediode ausgesandte Licht auf die Empfangsdiode fokussiert wird. Dabei ist die Fokussiereinrichtung vorzugsweise an den Lichtleiter direkt angeformt, nämlich beispielsweise als eine an den Kunststoff- bzw. Glaskörper direkt angeformte Linse ausgebildet.

Bei der Montage der Sendediode und der Empfangsdiode auf einer Leiterplatte ist gemäß einer bevorzugten Weiterbildung der Erfindung vorgesehen, daß auch der Lichtleiter auf der Leiterplatte befestigt ist. Vorzugsweise kommt dabei eine Befestigung des Lichtleiters zwischen den im Abstand voneinander auf der Leiterplatte angeordneten Photodioden in Betracht, wobei der Lichtleiter mit der Leiterplatte verklebt werden kann. Zusätzlich oder alternativ dazu kann eine Preßpassung des Lichtleiters auf der Leiterplatte vorgesehen sein, also z.B. durch das Einfügen von im Querschnitt rechteckigen oder quadratischen Füßen des Lichtleiters in kreisförmige Bohrungen in der Leiterplatte. Zusätzlich oder alternativ dazu können die Füße des Lichtleiters mit Rasthaken versehen sein, mit denen die Füße in den in der Leiterplatte vorgesehenen Bohrungen verrastet werden, nämlich in diesen einschnappen.

Grundsätzlich ist der Spektralbereich, in dem die Sendediode und die Empfangsdiode arbeiten, beliebig, solange der Spektralbereich der Sendediode auf den Spektralbereich der Empfangsdiode abgestimmt ist und der Lichtleiter in diesem Spektralbereich als Lichtleiter wirksam ist, also Totalreflektion zeigt und hinreichend transmissiv ist. Gemäß einer bevorzugten Weiterbildung der Erfindung ist jedoch vorgesehen, daß die Sendediode und die Empfangsdiode im infraroten Spektralbereich arbeiten. Damit können nämlich Störungen durch das Umgebungslicht weitestgehend ausgeschlossen werden. Der Ausschluß solcher Störungen wird gemäß einer bevorzugten Weiterbildung der Erfindung ferner dadurch erhöht, daß die Empfangsdiode einen im sichtbaren Spektralbereich wirksamen Filter aufweist.

Insgesamt gilt also, daß der erfindungsgemäße Optokoppler sehr einfach, nämlich mit herkömmlichen Photodioden, herstellbar ist, wobei der erforderliche Lichtleiter ebenfalls keine Schwierigkeiten bereitet, nämlich z.B. aus einem Kunststoffkörper mit einer geometrisch einfachen Form bestehen kann. Die Montage dieser Bestandteile erfolgt dann auf einer herkömmliche Leiterplatte, so daß der erfindungsgemäße Optokoppler insbesondere vollständig bei der Bestückung der Leiterplatte hergestellt werden kann, wobei die Bestükkung vorzugsweise im Prozeß der Oberflächenmontage erfolgt.

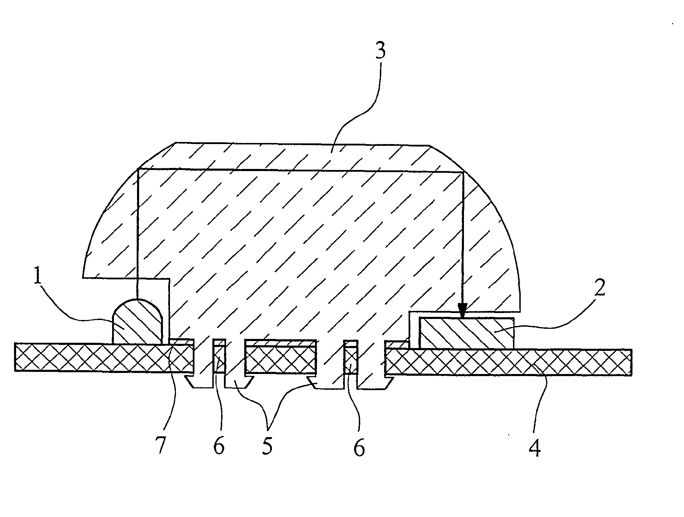

Im einzelnen gibt es nun eine Vielzahl von Möglichkeiten, den erfindungsgemäßen Optokoppler auszugestalten und weiterzubilden. Dazu wird auf die dem Patentanspruch 1 nachgeordneten Patentansprüche sowie auf die nachfolgende detaillierte Beschreibung eines bevorzugten Ausführungsbeispiels der Erfindung unter Bezugnahme auf die Zeichnung verwiesen. In der Zeichnung zeigt die einzige Figur einen Optokoppler gemäß einem bevorzugten Ausführungsbeispiel der Erfindung, der auf einer Leiterplatte befestigt ist.

Der aus der Figur ersichtliche Optokoppler gemäß dem bevorzugten Ausführungsbeispiel der Erfindung weist zwei Photodioden 1, 2 auf, nämlich eine Sendediode 1 und eine Empfangsdiode 2. Zwischen der Sendediode 1 und der Empfangsdiode 2 ist ein Lichtleiter 3 angeordnet, der von der Sendediode 1 ausgesandtes Licht auf die Empfangsdiode 2 führt. Bei dem Lichtleiter 3 handelt es sich um einen für das von den Photodioden 1, 2 verwendete Infrarotlicht transmissiven Kunststoffkörper aus Polycarbonat mit der Werkstoffnummer PCV 2302.

Wie aus der Figur ersichtlich, weist der Lichtleiter 3 eine einfache geometrische Form auf, ist nämlich derart ausgebildet, daß er zwischen den beiden Photodioden 1, 2 auf einer Leiterplatte 4 befestigt werden kann und dann bei der vorgesehenen Anordnung von Sendediode 1 einerseits und Empfangsdiode 2 andererseits das von der Sendediode 1 ausgesandte Infrarotlicht auf die Empfangsdiode 2 führt. Dazu überdeckt der Lichtleiter 3 mit einander gegenüberliegenden Außenbereichen die Sendediode 1 und die Empfangsdiode 2, die derart auf der Leiterplatte 4 befestigt sind, daß ihr Abstrahl- bzw. Empfangsbereich nach oben von der Leiterplatte 4 weg zeigen.

Wie mit einem von der Sendediode 1 zur Empfangsdiode 2 führenden Pfeil angedeutet, trifft das von der Sendediode 1 ausgesandte Licht innerhalb des Lichtleiters 3 unter einem den Grenzwinkel der Totalreflektion übersteigenden Winkel auf eine zur Abstrahlrichtung der Sendediode 1 hinreichend schräg verlaufende Begrenzungsfläche des Lichtleiters 3. Nach einer nochmaligen Reflektion innerhalb des Lichtleiters 3 an einer wiederum hinreichend schräg gegenüber der Ausbreitungsrichtung des einmal reflektierten Lichts verlaufenden Begrenzungsfläche trifft das Licht dann auf die Empfangsdiode 2.

Diese Begrenzungsflächen des Lichtleiters 3, an denen die Totalreflektionen stattfinden, könnten eben sein, gemäß dem hier beschriebenen bevorzugten Ausführungsbeispiel der Erfindung sind diese Begrenzungsfläche jedoch gekrümmt. Vorliegend ist nämlich vorgesehen, daß der Lichtleiter 3 zumindest in den für die Totalreflektion verantwortlichen Bereichen linsenförmig ist. Daß im mittleren Bereich des Lichtleiters 3 von einer solchen Linsenform abgesehen worden ist, der Lichtleiter dort nämlich plan verläuft, resultiert lediglich daher, daß auf diese Weise eine niedrigere Bauweise des Lichtleiters 3 und damit des Optokopplers insgesamt erzielt wird.

Zur Gewährleistung des schon angesprochenen Explosionsschutzes ist der Lichtleiter 3 derart dimensioniert, daß die Sendediode 1 in einem Abstand von wenigstens 10 mm von der Empfangsdiode 2 auf der Leiterplatte 4 angeordnet werden muß. Wie zuvor schon angesprochen und aus der Figur erkennbar, sind die Sendediode 1 und die Empfangsdiode 2 dabei jeweils so auf der Leiterplatte 4 angeordnet, daß ihr Abstrahl- bzw. Empfangsbereich von der Leiterplatte 4 nach oben weg gerichtet ist. Eine solche Anordnung der Photodioden 1, 2 ist sehr einfach und läßt sich ohne weiteres im Rahmen einer Oberflächenmontage erzielen. Ferner ergibt sich damit kaum der Bedarf einer nachträglichen Ausrichtung der Photodioden 1, 2 nach ihrer Montage auf der Leiterplatte; die Photodioden 1, 2 können also direkt so montiert werden, wie sie dann für den Optokoppler verwendet werden.

Auch die Befestigung des Lichtleiters 3 auf der Leiterplatte 4 ist sehr einfach, der Lichtleiter 3 wird nämlich mittels zweier Füße 5 in diesen entsprechende Bohrungen 6 in der Leiterplatte 4 eingesetzt. Zur Fixierung des Lichtleiters 3 auf der Leiterplatte 4 dienen, wie aus der Figur ersichtlich, am Ende der Füße 5 vorgesehene Rasthaken, mit denen die Füße 5 in den Bohrungen 6 verrastet werden. Darüber hinaus kann alternativ oder zusätzlich eine durch eine Klebeschicht 7 angedeutete Verklebung auf der Leiterplatte 4 vorgesehen sein.

## Patentansprüche

1. Optokoppler, mit zwei Photodioden (1, 2) und einem Lichtleiter (3), wobei von den beiden Photodioden (1, 2) die eine als Sendediode (1) und die andere als Empfangsdiode (2) vorgesehen ist und mit dem Lichtleiter (3) von der Sendediode (1) ausgesandtes Licht auf die Empfangsdiode (2) geführt wird, **dadurch gekennzeichnet, daß** die Sendediode (1) und die Empfangsdiode (2) im Abstand voneinander auf einer Leiterplatte (4) angeordnet sind und als Lichtleiter (3) ein ebenfalls auf der Leiterplatte angeordneter Kunststoff- oder Glaskörper vorgesehen ist.

2. Optokoppler nach Anspruch 1, **dadurch gekennzeichnet, daß** der Lichtleiter (3) zwischen der Sendediode (1) und der Empfangsdiode (2) auf der Leiterplatte (4) befestigt ist.

3. Optokoppler nach Anspruch 1 oder 2, **dadurch gekennzeichnet, daß** der Abstrahlbereich der Sendediode (1) oder/und der Empfangsbereich der Empfangsdiode (2) von der Leiterplatte (4) weg gerichtet sind.

4. Optokoppler nach Anspruch 3, **dadurch gekennzeichnet, daß** der Lichtleiter (3) die Sendediode (1) oder/und die Empfangsdiode (2) zumindest teilweise überdeckt.

5. Optokoppler nach Anspruch 4, **dadurch gekennzeichnet, daß** der Lichtleiter (3) zumindest teilweise linsenförmig ist.

6. Optokoppler nach Anspruch 5, **dadurch gekennzeichnet, daß** der Lichtleiter (3) aus Polycarbonat hergestellt ist.

7. Optokoppler nach Anspruch 5 oder 6, **dadurch gekennzeichnet, daß** der Lichtleiter (3) in einem Spritzgußverfahren hergestellt ist.

8. Optokoppler nach einem der Ansprüche 1 bis 7, **dadurch gekennzeichnet, daß** eine Fokussiereinrichtung vorgesehen ist, mit der das von der Sendediode (1) ausgesandte Licht auf die Empfangsdiode (2) fokussiert wird.

9. Optokoppler nach Anspruch 8, **dadurch gekennzeichnet, daß** die Fokussiereinrichtung an den Lichtleiter (3) angeformt ist, vorzugsweise in Form einer Linse.

10. Optokoppler nach einem der Ansprüche 1 bis 9, **dadurch gekennzeichnet, daß** die Sendediode (1) und die Empfangsdiode (2) im infraroten Spektralbereich arbeiten.

11. Optokoppler nach Anspruch 10, **dadurch gekennzeichnet, daß** die Empfangsdiode (2) einen im sichtbaren Spektralbereich wirksamen Filter aufweist.
